# EUROPEAN PATENT APPLICATION

(11) **EP 4 549 972 A1**
(43) Date of publication of application: **07.05.2025**
(21) Application number: 23895006.7
(22) Date of filing: 21.11.2023
(51) Int. Cl.: G01R 31/392, G01R 31/367, G01R 31/3842, G01R 31/396

(54) **APPARATUS AND METHOD FOR ESTIMATING STATE OF HEALTH OF BATTERY**

(30) Priority: 22.11.2022 KR 20220157819
(71) Applicant: LG Energy Solution, Ltd., Seoul 07335 (KR)
(72) Inventor: KIM, Young-Jin, Daejeon 34122 (KR)
(74) Representative: Plasseraud IP
(86) International application number: PCT/KR2023/018817
(87) International publication number: WO 2024/112079

(57) **Abstract**

A battery SOH estimating apparatus according to an embodiment of the present disclosure includes a battery information obtaining unit configured to obtain battery information including at least one of voltage, current, temperature, and SOC; and a control unit configured to calculate deterioration information for the battery from the battery information, preset reference information and preset acceleration information based on a preset deterioration model, and estimate SOH for the battery from the deterioration information based on a preset non-linear estimation model.

## Description

### TECHNICAL FIELD

The present application claims priority to Korean Patent Application No. 10-2022-0157819 filed on November 22, 2022 in the Republic of Korea, the disclosures of which are incorporated herein by reference.

The present disclosure relates to a battery SOH estimating apparatus and method, and more particularly, to a battery SOH estimating apparatus and method capable of effectively estimating a SOH of a battery.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-discharging rate and high energy density.

Conventionally, various techniques have been applied to estimate the degree of deterioration of a battery. For example, a representative technique is to estimate the degree of deterioration of the battery by estimating SOH (state of health) based on capacity deterioration, based on the OCV (open circuit voltage) of the battery. The degree of deterioration of the battery estimated in this way may be a measure of the current lifespan of the battery.

However, this conventional technique estimates the degree of deterioration of the battery through comparison between the initial capacity of the battery and the current capacity, but there is a limit in obtaining information about what factors cause battery deterioration. For example, since battery deterioration may be affected by non-linear factors such as negative electrode side reaction, positive electrode side reaction, and transition metal dissolution, it is difficult to identify the deterioration factors using the conventional technique of estimating the degree of deterioration estimation.

In addition, even if the degree of deterioration estimated according to the conventional technique is applied to the same battery, the residual value of the battery may vary depending on factors affecting the degree of deterioration. In other words, there are limitations in accurately estimating the state of the battery using the conventional technique alone. Therefore, there is a need to develop technology that may estimate the state of the battery by considering various factors that affect the degree of deterioration of the battery.

### DISCLOSURE

### Technical Problem

The present disclosure is designed to solve the problems of the related art, and therefore the present disclosure is directed to providing a battery SOH estimating apparatus and method that may estimate the state of a battery by considering various factors that affect deterioration of the battery.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

A battery SOH estimating apparatus according to one aspect of the present disclosure may comprise a battery information obtaining unit configured to obtain battery information including at least one of voltage, current, temperature, and SOC; and a control unit configured to calculate deterioration information for the battery from the battery information, preset reference information and preset acceleration information based on a preset deterioration model, and estimate SOH for the battery from the deterioration information based on a preset non-linear estimation model.

The control unit may be configured to calculate first acceleration information from the battery information and the reference information based on the deterioration model, calculate second acceleration information based on the first acceleration information and a preset acceleration profile, and set the calculated second acceleration information as the acceleration information.

The control unit may be configured to determine a criterion range in the acceleration profile based on the temperature of the battery among the battery information and calculate the second acceleration information according to the result of comparing the determined criterion range and the first acceleration information.

The control unit may be configured to calculate the first acceleration information as the second acceleration information, when the first acceleration information falls within the criterion range.

The control unit may be configured to calculate an upper limit value of the criterion range as the second acceleration information, when the first acceleration information exceeds the criterion range.

The control unit may be configured to calculate a lower limit value of the criterion range as the second acceleration information, when the first acceleration information is less than the criterion range.

The control unit may be configured to estimate a reference SOH from the battery information based on a preset linear estimation model and set the reference information based on the SOH and the reference SOH.

The control unit may be configured to calculate a weight based on the SOH and the reference SOH, and set the value obtained by adding the weight to the deterioration information as the reference information.

The non-linear estimation model may be configured using a non-linear Kalman filter.

The linear estimation model may be configured using a linear Kalman filter.

The control unit may be configured to calculate a Kalman gain based on the SOH and the reference SOH as the weight, and set the value obtained by adding the Kalman gain to the deterioration information as the reference information.

The control unit may be configured to update the reference information based on the deterioration information, the SOH, and the reference SOH each time the SOH is estimated.

When calculating the deterioration information for the first time, the control unit may be configured to set a criterion value preset to correspond to the deterioration information of the battery in a BOL state as the reference information.

The control unit may be configured to calculate at least one of a negative electrode side reaction amount, a positive electrode side reaction amount, and a transition metal dissolution amount as the deterioration information.

A battery pack according to another aspect of the present disclosure may comprise the battery SOH estimating apparatus according to an aspect of the present disclosure.

A server according to still another aspect of the present disclosure may comprise the battery SOH estimating apparatus according to an aspect of the present disclosure.

A battery SOH estimating method according to another aspect of the present disclosure may comprise: a battery information obtaining step of obtaining battery information including at least one of voltage, current, temperature, and SOC; a deterioration information calculating step of calculating deterioration information for the battery from the battery information, preset reference information and preset acceleration information based on a preset deterioration model; and a SOH estimating step of estimating SOH for the battery from the deterioration information based on a preset non-linear estimation model.

A battery SOH estimating method according to still another aspect of the present disclosure may further comprise: a reference SOH estimating step of estimating a reference SOH from the battery information based on a preset linear estimation model, after the SOH estimating step; and a reference information setting step of setting the reference information based on the SOH and the reference SOH.

A battery SOH estimating method according to still another aspect of the present disclosure may further comprise: an acceleration information setting step of, after the SOH estimating step, calculating first acceleration information from the battery information and the reference information based on the deterioration model, calculating second acceleration information based on the first acceleration information and a preset acceleration profile, and setting the calculated second acceleration information as the acceleration information.

### Advantageous Effects

According to one aspect of the present disclosure, there is an advantage in that the SOH of the battery may be estimated based on various factors that affect the deterioration of the battery. In particular, the SOH of the battery may be estimated based on non-linear information about the battery.

The effects of the present disclosure are not limited to the above, and other effects not mentioned herein will be clearly understood by those skilled in the art from the appended claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically showing a battery SOH estimating apparatus according to an embodiment of the present disclosure.
FIG. 2 is a diagram schematically showing the operation configuration of the battery SOH estimating apparatus to estimate SOH of a battery according to an embodiment of the present disclosure.
FIG. 3 is a diagram schematically showing an acceleration profile according to an embodiment of the present disclosure.
FIG. 4 is a diagram showing a SOH estimation result according to an embodiment of the present disclosure along with a comparative example.
FIG. 5 is a diagram schematically showing a battery pack according to another embodiment of the present disclosure.
FIG. 6 is a diagram schematically showing a battery system according to still another embodiment of the present disclosure.
FIGS. 7 and 8 are diagrams schematically showing a battery SOH estimating method according to still another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, a preferred embodiment of the present disclosure will be described in detail with reference to the accompanying drawings.

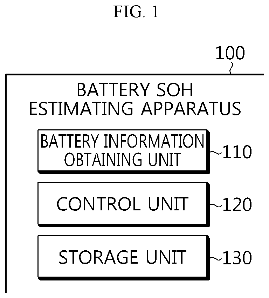

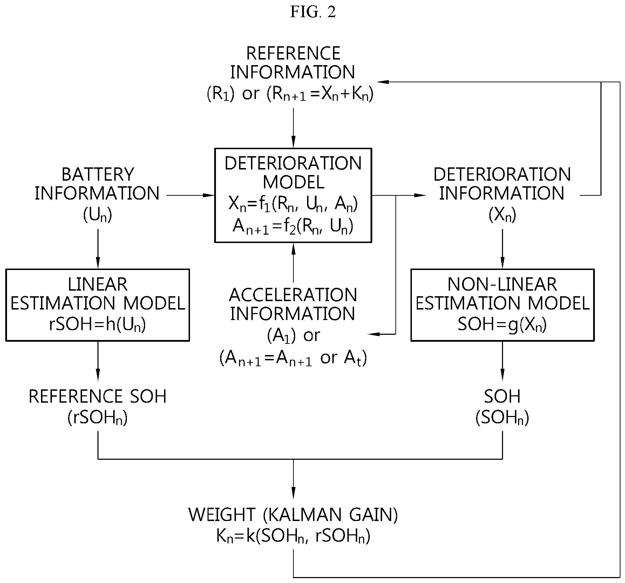

FIG. 1 is a diagram schematically showing a battery SOH estimating apparatus 100 according to an embodiment of the present disclosure. FIG. 2 is a diagram schematically showing the operation configuration of the battery SOH estimating apparatus 100 to estimate SOH of a battery according to an embodiment of the present disclosure.

Here, the battery refers to one physically separable independent cell having a negative electrode terminal and a positive electrode terminal. For example, a lithium-ion battery or a lithium polymer cell may be regarded as the battery. In addition, the battery may refer to a battery module or a battery pack in which a plurality of cells are connected in series and/or in parallel. Hereinafter, for convenience of description, the battery will be described as meaning one independent cell.

Referring to FIG. 1, the battery SOH estimating apparatus 100 may include a battery information obtaining unit 110 and a control unit 120.

The battery information obtaining unit 110 may be configured to obtain battery information including at least one of voltage, current, temperature, and SOC (state of charge).

Specifically, the voltage, current, and temperature may be information measured from the battery, and the SOC may be information estimated based on the measured information.

For example, the battery information obtaining unit 110 may receive and obtain battery information periodically or aperiodically. As another example, the battery information obtaining unit 110 may directly measure the voltage, current, and temperature of the battery periodically or aperiodically and estimate SOC based on the measured information.

The control unit 120 may be configured to calculate deterioration information about the battery from the battery information, preset reference information and preset acceleration information based on a preset deterioration model.

Specifically, the deterioration information is information that may be calculated based on at least one of the battery information, the preset reference information and the preset acceleration information, and may include information that may indicate a state of the battery that is changed electrochemically as the battery is deteriorated. For example, the deterioration information may include information that may quantitatively indicate a state change between a battery in a BOL (Beginning of Life) state and the current battery.

As a specific example, the control unit 120 may be configured to calculate at least one of a negative electrode side reaction amount, a positive electrode side reaction amount, and a transition metal dissolution amount as the deterioration information. For example, the deterioration model may include a first model for calculating the negative electrode side reaction amount, a second model for calculating the positive electrode side reaction amount, and a third model for calculating the transition metal dissolution amount.

The negative electrode side reaction amount may be the amount of side reaction generated when the negative electrode is reduced. For example, side reactions that may occur due to reduction of the negative electrode include electrolyte decomposition or the like in a graphite material metal. The control unit 120 may be configured to calculate the negative electrode side reaction amount of the battery from at least one of the battery information, the reference information and the acceleration information using the first model. For example, the control unit may calculate an electrolyte decomposition amount (i.e., negative electrode side reaction amount) in the graphite material metal using the battery information, the reference information and the acceleration information.

The positive electrode side reaction amount may be the amount of side reaction generated when the positive electrode is oxygenated. For example, side reactions that may occur due to oxidation of the positive electrode include electrolyte decomposition or the like in NCM (Ni, Co, Mn) materials. The control unit 120 may be configured to calculate the positive electrode side reaction amount of the battery from at least one of the battery information, the reference information and the acceleration information using the second model. For example, the control unit may calculate the electrolyte decomposition amount (i.e., positive electrode side reaction amount) in the NCM material using the battery information, the reference information and the acceleration information.

The transition metal dissolution amount may be the amount of dissolved transition metal. For example, the transition metal dissolution amount may mean the amount of precipitation of lithium metal. The control unit 120 may be configured to calculate the transition metal dissolution amount of the battery from at least one of the battery information, the reference information and the acceleration information using the third model. For example, the control unit may calculate the lithium metal precipitation amount (i.e., transition metal dissolution amount) using the battery information, the reference information and the acceleration information.

Also, the reference information may be information corresponding to the deterioration information. For example, the reference information may be a preset criterion value or a correction value of previously calculated deterioration information. A detailed description of the reference information will be described later.

Additionally, the acceleration information may be information indicating the degree of deterioration of the battery. For example, the acceleration information may be an indicator of the deterioration speed of the battery. In other words, the acceleration information may be a deterioration index that may numerically indicate how quickly the battery is being deteriorated. Specifically, the control unit may calculate acceleration information from the battery information and the reference information based on the deterioration model. A detailed explanation of the acceleration information will be provided later.

In the embodiment of FIG. 2, n means a time point and is assumed to have a value of 1 or more. The control unit 120 may input battery information (Uₙ), reference information (Rₙ) and acceleration information (Aₙ) into the deterioration model. The deterioration model may be set in advance to output deterioration information (Xₙ) by putting the received battery information (Uₙ), reference information (Rₙ) and acceleration information (Aₙ) into the relational expression (Xₙ= f₁(Rₙ, Uₙ, Aₙ)). The control unit 120 may calculate deterioration information (Xₙ) from the battery information (Uₙ), the reference information (Rₙ) and the acceleration information (Aₙ) using a deterioration model.

For example, when there is a plurality of deterioration information output through the deterioration model, a number of reference information corresponding to the number of deterioration information may be input to the deterioration model. That is, the reference information may be set in advance to correspond to the deterioration information to be output from the deterioration model. As a specific example, when the deterioration information output through the deterioration model includes a negative electrode side reaction amount, a positive electrode side reaction amount, and a transition metal dissolution amount, each reference information corresponding to the negative electrode side reaction amount, the positive electrode side reaction amount, and the transition metal dissolution amount may be input into the deterioration model.

The control unit 120 may be configured to estimate the SOH for the battery from the deterioration information based on a preset non-linear estimation model.

Here, the non-linear estimation model may be configured using a non-linear Kalman filter. For example, the non-linear estimation model may be a non-linear Kalman filter such as an extended Kalman filter (EKF) or a sigma point Kalman filter (SPKF).

Specifically, the control unit 120 may estimate the SOH of the battery by inputting deterioration information calculated using the deterioration model into a non-linear estimation model. That is, the control unit 120 may estimate the battery SOH using the non-linear estimation model in order to estimate the battery SOH by considering the non-linearity of the deterioration information.

In the embodiment of FIG. 2, the control unit 120 may input deterioration information (Xₙ) into the non-linear estimation model. The non-linear estimation model may be preset to output SOH (SOHₙ) by putting the input deterioration information (Xₙ) into the relational equation (SOH = g(Xₙ)). The control unit 120 may estimate the SOH (SOHₙ) of the battery from the deterioration information (Xₙ) using the non-linear estimation model.

In general, batteries may be deteriorated due to various factors, and the main deterioration pattern may also appear differently for each battery. For example, the first battery may have a negative electrode side reaction as the main deterioration pattern, and the second battery may have a positive electrode side reaction as the main deterioration pattern. Also, the deterioration information of the battery may be non-linear information.

Therefore, the battery SOH estimating apparatus 100 has the advantage of calculating deterioration information closely related to the degree of deterioration of the battery from the battery information, the reference information and the acceleration information and estimating the SOH of the battery considering the non-linearity of the calculated deterioration information. That is, because the SOH estimated by the battery SOH estimating apparatus 100 is estimated based on non-linear deterioration information, it may better represent the current state of the battery than the SOH estimated directly from the battery information.

Meanwhile, the control unit 120 included in the battery SOH estimating apparatus may optionally include processors, application-specific integrated circuits (ASICs), other chipsets, logic circuits, registers, communication modems, data processing devices, etc. known in the art to execute various control logics performed in the present disclosure. Also, when the control logic is implemented as software, the control unit 120 may be implemented as a set of program modules. At this time, the program module may be stored in the memory and executed by the control unit 120. The memory may be inside or outside the control unit 120 and may be connected to the control unit 120 by various well-known means.

In addition, the battery SOH estimating apparatus 100 may further include a storage unit 130. The storage unit 130 may store data necessary for operation and function of each component of the battery SOH estimating apparatus 100, data generated in the process of performing the operation or function, or the like. The storage unit 130 is not particularly limited in its kind as long as it is a known information storage means that can record, erase, update and read data. As an example, the information storage means may include RAM, flash memory, ROM, EEPROM, registers, and the like. In addition, the storage unit 130 may store program codes in which processes executable by the control unit 120 are defined.

For example, the storage unit 130 may store the battery information obtained by the battery information obtaining unit 110. Additionally, the storage unit 130 may store the deterioration information, the reference information, the SOH, and the reference SOH calculated by the control unit 120.

Below, an embodiment in which the control unit 120 sets the acceleration information will be described in detail.

The control unit 120 may be configured to calculate first acceleration information from the battery information and the reference information based on a deterioration model.

Specifically, the control unit 120 may input the battery information, the reference information, and the acceleration information into the deterioration model and calculate the deterioration information and the acceleration information.

The control unit 120 may input the battery information (Uₙ), the reference information (Rₙ), and the acceleration information (Aₙ) into the deterioration model. The deterioration model may be preset to output the deterioration information (Xₙ) by substituting the input battery information (Uₙ), the reference information (Rₙ), and the acceleration information (Aₙ) into the relational equation (Xₙ = f₁(Rₙ, Uₙ, Aₙ)). Additionally, the deterioration model may be preset to output the acceleration information (Aₙ₊₁) by substituting the input battery information (Uₙ) and the reference information (Rₙ) into the relational equation (Aₙ₊₁ = f₂(Rₙ, Uₙ)). That is, from the battery information (Uₙ), the reference information (Rₙ), and the acceleration information (Aₙ) at the n^{th} time point, the deterioration information (Xₙ) at the n^{th} time point and the acceleration information (Aₙ₊₁) at the n+1^{th} time point may be calculated.

The control unit 120 may be configured to calculate second acceleration information based on the first acceleration information and the preset acceleration profile. Additionally, the control unit 120 may be configured to set the calculated second acceleration information as the acceleration information.

Specifically, the control unit 120 may be configured to determine the criterion range in the acceleration profile based on the temperature of the battery among the battery information.

Here, the acceleration profile may be a profile in which the corresponding relationship between the temperature of the battery and the acceleration information is preset. Specifically, the acceleration profile may be a profile in which the upper limit value and lower limit value of the acceleration information depending on the temperature of the battery are preset. Accordingly, the control unit 120 may determine the criterion range (range from the lower limit value to the upper limit value) corresponding to the battery temperature based on the acceleration profile.

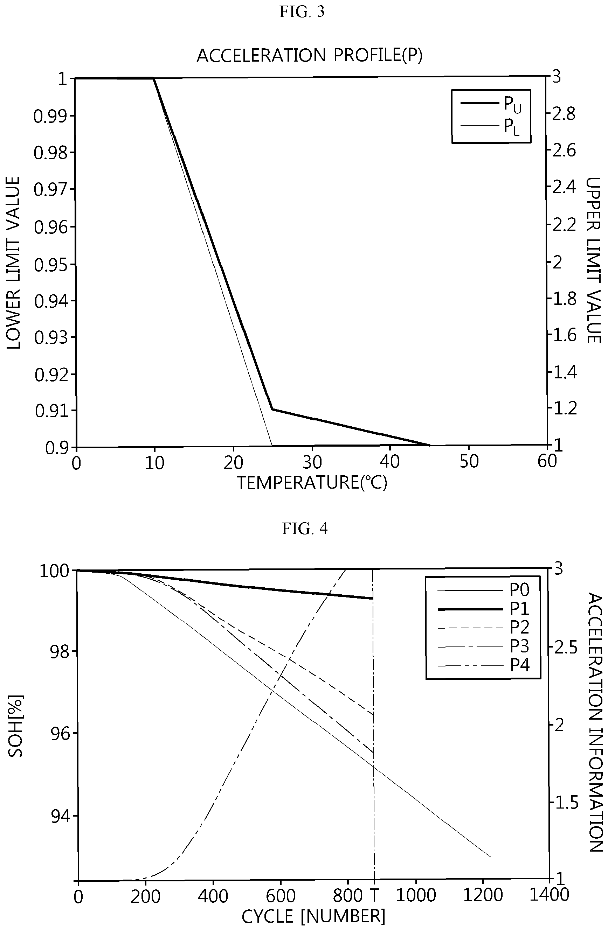

FIG. 3 is a diagram schematically showing an acceleration profile P according to an embodiment of the present disclosure.

Referring to FIG. 3, the acceleration profile P may be a profile in which the upper limit value (P_{U}) and lower limit value (P_{L}) of the acceleration information about the temperature are to be preset. For example, if the temperature is 25°C, the upper limit value (P_{U}) of the criterion range may be 1.2 and the lower limit value (P_{L}) may be 0.9. As another example, if the temperature is below 10°C, the upper limit value (P_{U}) of the criterion range may be 3 and the lower limit value (P_{L}) may be 1.

Additionally, the control unit 120 may be configured to calculate second acceleration information according to the result of comparing the determined criterion range and the first acceleration information.

Specifically, the control unit 120 may calculate second acceleration information depending on whether the first acceleration information falls within the criterion range. That is, the control unit 120 may compare the first acceleration information and the criterion range, and calculate the first acceleration information, the upper limit value of the criterion range, or the lower limit value of the criterion range as the second acceleration information based on the comparison result.

For example, if there are no limitations on the upper and lower limits of the acceleration information calculated by the deterioration model, depending on the embodiment, acceleration information having an excessively large value or an excessively small value may be applied to calculate the deterioration information. In the embodiment of FIG. 2, because the acceleration information (Aₙ₊₁) and the reference information (Rₙ₊₁) may be recursively re-entered into the deterioration model, if incorrect acceleration information (Aₙ₊₁) is calculated by the deterioration model, errors may accumulate in the subsequently estimated SOH (SOHₙ). Therefore, the control unit 120 may compare the first acceleration information calculated based on the deterioration model and the criterion range according to the preset acceleration profile, and set the second acceleration information calculated based on the comparison result as the acceleration information.

For example, if the first acceleration information falls within the criterion range, the control unit 120 may calculate the first acceleration information as the second acceleration information. That is, if the first acceleration information is included within the determined criterion range, the control unit 120 may set the first acceleration information as the second acceleration information. For example, in the embodiment of FIG. 2, the first acceleration information (Aₙ₊₁) output from the deterioration model may be set as the second acceleration information as it is. That is, in the embodiment of FIG. 2, it may correspond to Aₙ₊₁ = Aₙ₊₁.

As another example, if the first acceleration information exceeds the criterion range, the control unit 120 may calculate the upper limit value of the criterion range as the second acceleration information. That is, if the first acceleration information exceeds the upper limit value of the criterion range, the control unit 120 may set the upper limit value of the criterion range to the second acceleration information. For example, in the embodiment of FIG. 2, if the first acceleration information (Aₙ₊₁) output from the deterioration model exceeds the criterion range, the upper limit value (At) of the criterion range may be set as the second acceleration information. That is, in the embodiment of FIG. 2, it may correspond to Aₙ₊₁ = Aₜ.

As still another example, if the first acceleration information is less than the criterion range, the control unit 120 may calculate the lower limit value of the criterion range as the second acceleration information. That is, if the first acceleration information is less than the lower limit value of the criterion range, the control unit 120 may set the lower limit value of the criterion range as the second acceleration information. For example, in the embodiment of FIG. 2, if the first acceleration information (Aₙ₊₁) output from the deterioration model exceeds the criterion range, the lower limit value (Aₜ) of the criterion range may be set as the second acceleration information. That is, in the embodiment of FIG. 2, it may correspond to Aₙ₊₁ = Aₜ.

Meanwhile, when the deterioration information is calculated for the first time, the control unit 120 may input BOL acceleration information preset to correspond to a battery in a BOL state into the deterioration model.

In the embodiment of FIG. 2, A₁ may represent BOL acceleration information preset to correspond to the battery in the BOL state. When the deterioration information (X₁) is calculated by the control unit 120, since previously calculated deterioration information (X₀) does not exist, the preset BOL acceleration information (A₁) may be input to the deterioration model as the acceleration information.

The battery SOH estimating apparatus according to an embodiment of the present disclosure has the advantage of being able to more accurately estimate the current state of the battery because it estimates SOH by further considering the acceleration information indicating the deterioration rate of the battery.

Below, an embodiment in which the control unit 120 sets reference information will be described in detail.

The control unit 120 may be configured to estimate a reference SOH from the battery information based on a preset linear estimation model.

Here, the linear estimation model may be configured using a linear Kalman filter. For example, the linear estimation model may be a linear Kalman filter such as a Kalman filter (KF).

In the embodiment of FIG. 2, the control unit 120 may input battery information (Uₙ) into the linear estimation model. The linear estimation model may be preset to output the reference SOH (rSOHₙ) by putting the input battery information (Uₙ) into the relational equation (rSOH = h(Uₙ)). The control unit 120 may estimate the reference SOH (rSOHₙ) of the battery from the battery information (Uₙ) using the linear estimation model.

The reference SOH (rSOHₙ) is a value calculated from the battery information (Uₙ) using a linear estimation model, and the SOH (SOHₙ) is a value calculated from the deterioration information (Xₙ) using a non-linear estimation model. In other words, the reference SOH (rSOHₙ) and the SOH (SOHₙ) have a difference in terms of the factors to be considered (battery information and deterioration information), the nature of the factors to be considered (linearity and non-linearity), and the type of estimation models (linear estimation model and non-linear estimation model).

Additionally, the control unit 120 may be configured to set reference information based on the SOH and the reference SOH.

Specifically, the reference information may be a preset criterion value or a correction value of previously calculated deterioration information. In the embodiment of FIG. 2, the reference information may be R₁ or Rₙ₊₁.

When the deterioration information is calculated for the first time, the control unit 120 may be configured to set a criterion value preset to correspond to the deterioration information of the battery in the BOL state as the reference information.

In the embodiment of FIG. 2, R₁ may represent a criterion value preset to correspond to the deterioration information of the battery in the BOL state. When the deterioration information (X₁) is calculated by the control unit 120, since previously calculated deterioration information (X₀) does not exist, the preset criterion value (R₁) may be input to the deterioration model as the reference information.

If the deterioration information is not calculated for the first time (if the deterioration information is previously calculated), the control unit 120 may be configured to update the reference information based on the deterioration information, the SOH, and the reference SOH each time the SOH is estimated.

In the embodiment of FIG. 2, the control unit 120 may calculate reference information (Rₙ₊₁) by inputting the deterioration information (Xₙ) and the weight (Kₙ) into the relational equation (Rₙ₊₁ = Xₙ + Kₙ). Here, the reference information (Rₙ₊₁) calculated at the time point n may be input into the deterioration model (Xₙ₊₁ = f₁(Rₙ₊₁, Uₙ₊₁, Aₙ₊₁)) at the time point n+1. The reference information calculated at a previous time point may be used to calculate deterioration information at a next time point. In other words, the reference information may be used to calculate deterioration information at the next time point through a recursive structure.

Specifically, the control unit 120 may be configured to calculate a weight based on the SOH and the reference SOH. The control unit 120 may be configured to set a value obtained by adding the weight to the deterioration information as the reference information.

Referring to the previous embodiment, assume that the non-linear estimation model is a non-linear Kalman filter and the linear estimation model is a linear Kalman filter. In this case, the control unit 120 may be configured to calculate a Kalman gain based on the SOH and the reference SOH as the weight. Additionally, the control unit 120 may be configured to set a value obtained by adding the Kalman gain to the deterioration information as the reference information.

Specifically, the Kalman gain may be calculated based on the SOH calculated from the non-linear Kalman filter and the reference SOH calculated from the linear Kalman filter. That is, the Kalman gain may be calculated based on the SOH and the reference SOH obtained from different estimation models. Also, the reference information may be updated by adding the Kalman gain calculated in this way to the deterioration information.

In the embodiment of FIG. 2, the control unit 120 may calculate a weight (Kₙ) by inputting the reference SOH (rSOHₙ) and the SOH (SOHₙ) into the relational equation (Kₙ = k(SOHₙ, rSOHₙ)). Here, the relational equation (Kₙ = k(SOHₙ, rSOHₙ)) may be preset to calculate the Kalman gain (Xₙ) between the reference SOH (rSOHₙ) and the SOH (SOHₙ). Also, the control unit 120 may calculate a reference information (Rₙ₊₁), which may be input into the deterioration model (Xₙ₊₁ = f₁(Rₙ₊₁, Uₙ₊₁, Aₙ₊₁)) at the time point n+1, by adding the Kalman gain (Kₙ) to the deterioration information (Xₙ) using the relational equation (Rₙ₊₁ = Xₙ + Kₙ)).

The battery SOH estimating apparatus 100 may update the reference information for calculating the deterioration information each time the SOH of the battery is estimated. That is, since the battery SOH estimating apparatus 100 not only updates the reference information to correspond to the current state of the battery but also estimates the SOH of the battery using the updated reference information, the SOH of the battery may be estimated with high accuracy.

FIG. 4 is a diagram showing a SOH estimation result according to an embodiment of the present disclosure along with a comparative example.

Specifically, FIG. 4 is a diagram showing various SOH profiles of the battery while T cycles are in progress.

P0 is a comparative example and is an SOH profile showing the actual SOH for the battery.

P1 is a comparative example and is an SOH profile using a conventional SOH estimation method. For example, in the embodiment of FIG. 2, the SOH profile for the reference SOH according to the linear estimation model may appear as P1. In other words, P1 is the result of estimating the SOH of the battery without considering non-linear factors such as negative electrode side reaction, positive electrode side reaction, and transition metal melting.

P2 is a comparative example and is a SOH profile corresponding to the case where the acceleration information is not considered in the deterioration model. For example, in the embodiment of FIG. 2, the deterioration model may calculate the deterioration information (Xₙ) based on the relational equation (Xₙ = f₁(Rₙ, Uₙ)). In other words, P2 is the result of estimating the SOH of the battery without considering the acceleration information about the battery.

P3 is an embodiment of the present disclosure, and is a SOH profile corresponding to the case where the battery information, the reference information, and the acceleration information are all considered. For example, in the embodiment of FIG. 2, the deterioration model calculates the deterioration information (Xₙ) based on the relational equation (Xₙ = f₁(Rₙ, Uₙ, Aₙ)), and the non-linear estimation model may calculate the SOH (SOHₙ) based on the relational equation (SOH = g(Xₙ)). That is, P3 is the result of estimating the SOH of the battery according to the embodiment of FIG. 2.

P4 is a profile regarding the acceleration information used by the battery SOH estimating apparatus 100 in the process of estimating the SOH of the battery according to an embodiment of the present disclosure. For example, in the embodiment of FIG. 4, the battery SOH estimating apparatus 100 uses the acceleration information according to P4 when estimating the SOH of the battery according to P3. In other words, the acceleration information according to P4 is calculated in the process of estimating the SOH of the battery according to P3.

The battery SOH estimating apparatus 100 according to the present disclosure may be applied to a battery management system (BMS). That is, the BMS according to the present disclosure may include the battery SOH estimating apparatus 100 described above. In this configuration, at least some of components of the battery SOH estimating apparatus 100 may be implemented by supplementing or adding functions of the components included in a conventional BMS. For example, the battery information obtaining unit 110, the control unit 120 and the storage unit 130 of the battery SOH estimating apparatus 100 may be implemented as components of the BMS.

In addition, the battery SOH estimating apparatus 100 according to the present disclosure may be provided to a battery pack. That is, the battery pack according to the present disclosure may include the above-described battery SOH estimating apparatus 100 and one or more battery cells. In addition, the battery pack may further include electrical components (a relay, a fuse and the like) and a case.

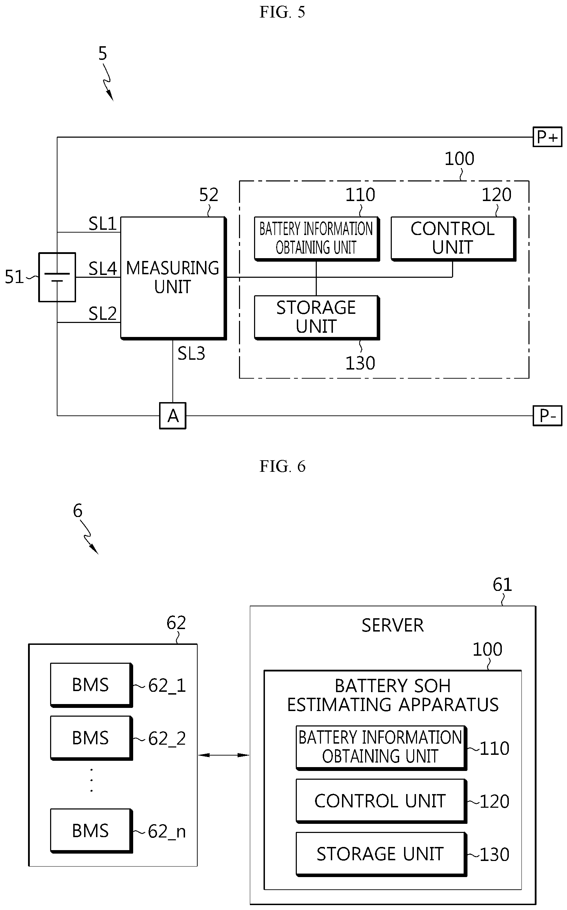

FIG. 5 is a diagram schematically showing a battery pack according to another embodiment of the present disclosure.

The positive electrode terminal of the battery 51 may be connected to the positive electrode terminal P+ of the battery pack 5, and the negative electrode terminal of the battery 51 may be connected to the negative electrode terminal P- of the battery pack 5.

The measuring unit 52 may be connected to the first sensing line SL1, the second sensing line SL2, the third sensing line SL3 and the fourth sensing line SL4.

Specifically, the measuring unit 52 may be connected to the positive electrode terminal of the battery 51 through the first sensing line SL1, and may be connected to the negative electrode terminal of the battery 51 through the second sensing line SL2. The measuring unit 52 may measure the voltage of the battery 51 based on the voltage measured at each of the first sensing line SL1 and the second sensing line SL2.

In addition, the measuring unit 52 may be connected to the current measuring unit A through the third sensing line SL3. For example, the current measuring unit A may be an ammeter or a shunt resistor capable of measuring the charging current and the discharging current of the battery 51. The measuring unit 52 may calculate the charge amount by measuring the charging current of the battery 51 through the third sensing line SL3. Also, the measuring unit 52 may calculate the discharge amount by measuring the discharging current of the battery 51 through the third sensing line SL3.

Also, the measuring unit 52 may measure the temperature of the battery 51 through the fourth sensing line SL4.

An external device (not shown) may be connected to the positive electrode terminal P+ and the negative electrode terminal P- of the battery pack 5. For example, the external device may be a charging device or a load that receives power from the battery 51.

The battery information obtaining unit 110 may obtain battery information about the voltage, current, and temperature of the battery 51 from the measuring unit 52. Additionally, the measuring unit 52 may estimate the SOC of the battery 51 based on the measured information and transmit the estimated SOC to the battery information obtaining unit 110.

Meanwhile, in another embodiment of the present disclosure, the battery information obtaining unit 110 may be directly connected to the first to fourth sensing lines SL1, SL2, SL3, SL4 to directly measure the voltage, current, and temperature of the battery 51. In addition, the battery information obtaining unit 110 may directly estimate the SOC of the battery 51 based on the measured information.

FIG. 6 is a diagram schematically showing a battery system 6 according to still another embodiment of the present disclosure.

Referring to FIG. 6, the battery system may include at least one BMS 62 and a server 61. Additionally, the server 61 may include the battery SOH estimating apparatus 100. For example, the server 61 may be a cloud server.

The server 61 may be connected to communicate with at least one BMS 62. Preferably, the server 61 may be connected to the BMS 62 to enable wired and/or wireless communication.

Each BMS 62 may collect battery information of the connected battery and transmit the collected battery information to the server 61. Afterwards, the server 61 may estimate the SOH of the battery connected to each BMS 62 based on the received battery information.

For example, assume that each BMS 62 is a BMS provided in a different vehicle. The first BMS 62_1, the second BMS 62_2, and the n^{th} BMS 62_n may each collect battery information about the corresponding battery and transmit the collected battery information to the server 61 through wireless communication. The server 61 may estimate the SOH of the first battery included in a first vehicle corresponding to the first BMS 62_1 based on the battery information received from the first BMS 62_1. Also, the server 61 may estimate the SOH of the second battery included in a second vehicle corresponding to the second BMS 62_2 based on the battery information received from the second BMS 62_2. Additionally, the server 61 may estimate the SOH of the n^{th} battery included in an n^{th} vehicle corresponding to the n^{th} BMS 62_n based on the battery information received from the n^{th} BMS 62_n.

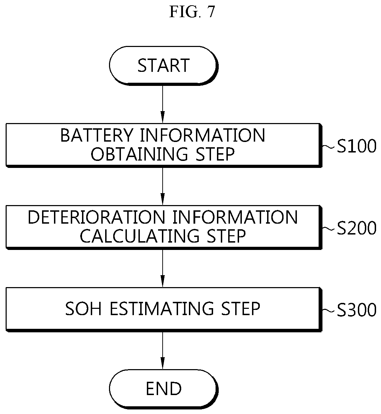

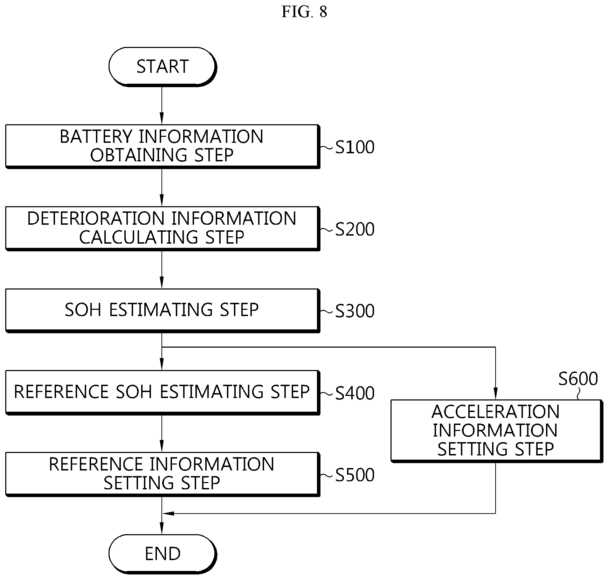

FIGS. 7 and 8 are diagrams schematically showing a battery SOH estimating method according to still another embodiment of the present disclosure.

Preferably, each step of the battery SOH estimating method may be performed by the battery SOH estimating apparatus 100. Hereinafter, for convenience of explanation, the content overlapping with the previously described content will be omitted or briefly described.

Referring to FIG. 7, the battery SOH estimating method may include a battery information obtaining step (S100), a deterioration information calculating step (S200), and a SOH estimating step (S300).

The battery information obtaining step (S100) is a step of obtaining battery information including at least one of voltage, current, temperature, and SOC, and may be performed by the battery information obtaining unit 110.

For example, the battery information obtaining unit 110 may obtain the battery information by receiving it through a communication network. As another example, the battery information obtaining unit 110 may directly measure and estimate battery information.

The deterioration information calculating step (S200) is a step of calculating deterioration information for the battery from the battery information, preset reference information and preset acceleration information based on a preset deterioration model, and may be performed by the control unit 120.

For example, the control unit 120 may calculate the deterioration information about the battery by inputting the battery information, the reference information and the acceleration information into a preset deterioration model.

Here, the deterioration information may include information that may quantitatively compare and determine the degree of deterioration of the battery, such as a negative electrode side reaction amount, a positive electrode side reaction amount, and a transition metal dissolution amount.

The SOH estimating step (S300) is a step of estimating SOH for the battery from the deterioration information based on a preset non-linear estimation model, and may be performed by the control unit 120.

For example, the control unit 120 may estimate the SOH for the battery by inputting the deterioration information into a preset non-linear estimation model.

Here, the non-linear estimation model may be a model preset to estimate the SOH of the battery from the deterioration information with non-linearity. For example, the non-linear estimation model may be a non-linear Kalman filter such as EKF or SPKF.

Referring to FIG. 8, the battery SOH estimating method may further include a reference SOH estimating step (S400), a reference information setting step (S500) and an acceleration information setting step (S600).

The reference SOH estimating step (S400) is a step of estimating a reference SOH from the battery information based on a preset linear estimation model after the SOH estimating step (S300), and may be performed by the control unit 120.

For example, the control unit 120 may estimate the reference SOH for the battery by inputting the battery information into a linear estimation model.

Here, the linear estimation model may be a model preset to estimate the reference SOH of the battery from the battery information having linearity. For example, the linear estimation model may be a linear Kalman filter such as KF.

The reference information setting step (S500) is a step of setting reference information based on the SOH and the reference SOH, and may be performed by the control unit 120.

For example, the control unit 120 may calculate a Kalman gain between the estimated SOH and the estimated reference SOH. Additionally, the control unit 120 may set reference information by adding the Kalman gain to the deterioration information. The reference information set in this way may be used to calculate the deterioration information of the battery at the next time point. In other words, the reference information set at the current time point may be input into the deterioration model at the next time point.

The acceleration information setting step (S600) is a step of, after the SOH estimating step (S300), calculating first acceleration information from the battery information and the reference information based on the deterioration model, calculating second acceleration information based on the first acceleration information and a preset acceleration profile, and setting the calculated second acceleration information as the acceleration information, and may be performed by the control unit.

Preferably, the acceleration information setting step (S600) may be performed in parallel with the reference SOH estimating step (S400) and the reference information setting step (S500).

For example, the control unit 120 may calculate the first acceleration information from the battery information and the reference information using a deterioration model. Additionally, the control unit 120 may determine a criterion range corresponding to the temperature of the battery based on the preset acceleration profile. The control unit 120 may compare the first acceleration information and the criterion range, and calculate the first acceleration information, the upper limit value of the criterion range, or the lower limit value of the criterion range as the second acceleration information based on the comparison result. Finally, the control unit 120 may set the calculated second acceleration information as acceleration information that may be input to the deterioration model in the next cycle.

The embodiments of the present disclosure described above may not be implemented only through an apparatus and method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

In addition, since the present disclosure described above can be substituted, modified and changed in various ways by those skilled in the art without departing from the technical idea of the present disclosure, the present disclosure is not limited by the embodiments described above and the accompanying drawings, and all or some of the embodiments may be selectively combined to enable various modifications.

### (Explanation of reference signs)

5: battery pack
51: battery
52: measuring unit
6: battery system
61: server
62: BMS
100: battery SOH estimating apparatus
110: battery information obtaining unit
120: control unit
130: storage unit

## Claims

1. A battery SOH estimating apparatus, comprising:
a battery information obtaining unit configured to obtain battery information including at least one of voltage, current, temperature, and SOC; and
a control unit configured to calculate deterioration information for the battery from the battery information, preset reference information and preset acceleration information based on a preset deterioration model, and estimate SOH for the battery from the deterioration information based on a preset non-linear estimation model.

2. The battery SOH estimating apparatus according to claim 1,
wherein the control unit is configured to calculate first acceleration information from the battery information and the reference information based on the deterioration model, calculate second acceleration information based on the first acceleration information and a preset acceleration profile, and set the calculated second acceleration information as the acceleration information.

3. The battery SOH estimating apparatus according to claim 2,
wherein the control unit is configured to determine a criterion range in the acceleration profile based on the temperature of the battery among the battery information and calculate the second acceleration information according to the result of comparing the determined criterion range and the first acceleration information.

4. The battery SOH estimating apparatus according to claim 3,
wherein the control unit is configured to:
calculate the first acceleration information as the second acceleration information, when the first acceleration information falls within the criterion range,
calculate an upper limit value of the criterion range as the second acceleration information, when the first acceleration information exceeds the criterion range, and
calculate a lower limit value of the criterion range as the second acceleration information, when the first acceleration information is less than the criterion range.

5. The battery SOH estimating apparatus according to claim 1,
wherein the control unit is configured to estimate a reference SOH from the battery information based on a preset linear estimation model and set the reference information based on the SOH and the reference SOH.

6. The battery SOH estimating apparatus according to claim 5,
wherein the control unit is configured to calculate a weight based on the SOH and the reference SOH, and set the value obtained by adding the weight to the deterioration information as the reference information.

7. The battery SOH estimating apparatus according to claim 6,
wherein the non-linear estimation model is configured using a non-linear Kalman filter,
wherein the linear estimation model is configured using a linear Kalman filter, and
wherein the control unit is configured to calculate a Kalman gain based on the SOH and the reference SOH as the weight, and set the value obtained by adding the Kalman gain to the deterioration information as the reference information.

8. The battery SOH estimating apparatus according to claim 5,
wherein the control unit is configured to update the reference information based on the deterioration information, the SOH, and the reference SOH each time the SOH is estimated.

9. The battery SOH estimating apparatus according to claim 1,
wherein when calculating the deterioration information for the first time, the control unit is configured to set a criterion value preset to correspond to the deterioration information of the battery in a BOL state as the reference information.

10. The battery SOH estimating apparatus according to claim 1,
wherein the control unit is configured to calculate at least one of a negative electrode side reaction amount, a positive electrode side reaction amount, and a transition metal dissolution amount as the deterioration information.

11. A battery pack, comprising the battery SOH estimating apparatus according to any one of claims 1 to 10.

12. A server, comprising the battery SOH estimating apparatus according to any one of claims 1 to 10.

13. A battery SOH estimating method, comprising:
a battery information obtaining step of obtaining battery information including at least one of voltage, current, temperature, and SOC;
a deterioration information calculating step of calculating deterioration information for the battery from the battery information, preset reference information and preset acceleration information based on a preset deterioration model; and
a SOH estimating step of estimating SOH for the battery from the deterioration information based on a preset non-linear estimation model.

14. The battery SOH estimating method according to claim 13, further comprising:
a reference SOH estimating step of estimating a reference SOH from the battery information based on a preset linear estimation model, after the SOH estimating step; and
a reference information setting step of setting the reference information based on the SOH and the reference SOH.

15. The battery SOH estimating method according to claim 13, further comprising:
an acceleration information setting step of, after the SOH estimating step, calculating first acceleration information from the battery information and the reference information based on the deterioration model, calculating second acceleration information based on the first acceleration information and a preset acceleration profile, and setting the calculated second acceleration information as the acceleration information.
